# EUROPÄISCHE PATENTSCHRIFT

(11) **EP 2 955 249 B1**
(45) Veröffentlichungstag und Bekanntmachung des Hinweises auf die Patenterteilung: **27.06.2018**
(21) Anmeldenummer: 14178957.8
(22) Anmeldetag: 29.07.2014
(51) Int. Cl.: C23C 10/28, C25D 5/14, C25D 5/50, C23C 14/16, C23C 14/58, C25D 7/06

(54) **Verfahren zum Herstellen eines mit einem Korrosionsschutzsystem beschichteten Stahlblechs**
Method for the production of a steel sheet provided with a corrosion protection system
Procédé de fabrication d'une tôle d'acier revêtue d'un système anticorrosion

(30) Priorität: 12.06.2014 DE 102014008323
(43) Veröffentlichungstag der Anmeldung: 16.12.2015
(73) Patentinhaber: thyssenkrupp AG, 45143 Essen (DE); ThyssenKrupp Steel Europe AG, 47166 Duisburg (DE)
(72) Erfinder: Puls, Stefan Peter, 44141 Dortmund (DE); Strack, Michael, 45309 Essen (DE); Kuhn, Patrick, 44141 Dortmund (DE)
(74) Vertreter: Cohausz & Florack

(56) Entgegenhaltungen:
- EP-A1- 1 900 854
- WO-A2-2009/010473
- FR-A- 1 414 103
- GB-A- 303 034
- US-A- 2 402 834
- DATABASE WPI Week 199605 31. Dezember 1996 (1996-12-31) Thomson Scientific, London, GB; AN 1996-045613 XP002745571, & JP H07 310167 A (TOYO KOHAN CO LTD) 28. November 1995 (1995-11-28)

## Beschreibung

Die Erfindung betrifft ein Verfahren zum Herstellen eines mit einem Korrosionsschutzsystem beschichteten Stahlblechs, das auf einem als Grundschicht dienenden Stahlsubstrat aus unlegiertem oder niedriglegiertem Kohlenstoff-Stahl basiert.

Unter einem unlegiertem oder niedriglegiertem Kohlenstoff-Stahl wird im vorliegenden Kontext ein Stahl verstanden, der einen Kohlenstoffgehalt von bis zu 2,1 Gew.-%, einen Chromgehalt von bis zu 0,4 Gew.-% und einen Nickelgehalt von bis zu 0,4 Gew.-% aufweist.

Unter einem Stahlflachprodukt wird im vorliegenden Kontext ein Erzeugnis mit etwa rechteckigem Querschnitt verstanden, dessen Breite viel größer als seine Dicke ist. Das Stahlflachprodukt hat beispielsweise die Form eines Stahlblechs, insbesondere einer Stahlplatine, oder eines Stahlbandes.

Aufgrund schlechter Korrosionsbeständigkeit werden Stahlflachprodukte aus unbeschichtetem Kohlenstoffstahl üblicherweise mit einer Verzinkung gegen Korrosion geschützt. Aus Gründen der Ästhetik wird anschließend eine oft mehrschichtige, farbgebende organische Lackbeschichtung aufgetragen, welche die Korrosionsbeständigkeit weiter erhöht. Die zur Gewährleistung der Korrosionsschutz-und Lackhaftungswirkung in den Lacksystemen und Grundierungen enthaltenen chemischen Stoffe sind jedoch mitunter gesundheits- und umweltschädlich, da diese häufig Schwermetalle wie Nickel, Chrom(VI)-Ionen und Chrom(II)-Ionen beinhalten.

Bei farbgebenden organischen Lackbeschichtungen besteht zudem das Problem, dass diese bei intensiver UV-Lichteinwirkung relativ schnell ausbleichen.

Als Alternative zu verzinkten Stahlblechen aus Kohlenstoffstahl stehen zwar auch rostfreie Edelstahl- und Kupferbleche zur Verfügung, jedoch sind diese relativ teuer. Allgemein ist insbesondere Edelstahl aufgrund seiner metallischen Legierungselemente wie Chrom, Titan und Nickel ein relativ teures Material. Zurzeit werden rost- und säurebeständige Stähle als Eisenlegierungen mit Chrom- und Nickelanteilen von mehr als 10 Gew.-% sowie weiteren Legierungselementen mit Anteilen im Prozentbereich im Vollmaterial eingesetzt, um unter anderem in korrosionstechnisch besonders anspruchsvollen Umgebungen, wie etwa solchen, denen Hausgeräte, Spülen, chemische Anlagen und Gebäudefassaden ausgesetzt sind, eingesetzt zu werden.

Die DE 10 2006 047 060 A1 offenbart ein mit einem Korrosionsschutzsystem beschichtetes Stahlflachprodukt, das im beschichteten Zustand eine optimierte Kombination von Korrosionsbeständigkeit und Verschweißbarkeit besitzt. Hierzu weist das Stahlflachprodukt eine aus einem Stahl gebildete Grundschicht und ein auf die Grundschicht aufgebrachtes Korrosionsschutzsystem auf, das einen weniger als 3,5 µm dicken metallischen Überzug, der aus einer ersten auf die Grundschicht aufgetragenen metallischen Schicht und einer auf die erste metallische Schicht aufgebrachten zweiten metallischen Schicht gebildet ist, wobei die zweite metallische Schicht in Folge einer Wärmebehandlung mit der ersten metallischen Schicht eine metallische Legierung gebildet hat, und eine auf den metallischen Überzug aufgebrachte Plasmapolymerschicht umfasst. Bei der ersten metallischen Schicht handelt es sich beispielsweise um einen Reinzinküberzug, der sich durch elektrolytisches Verzinken, Feuerverzinken oder Vakuumbedampfung auf dem Stahlsubstrat aufbringen lässt. Alternativ kann der erste metallische Überzug des aus der DE 10 2006 047 060 A1 bekannten Stahlflachprodukts auch aus Al, einer Zn-Ni-, einer Zn-Fe- oder einer Zn-Al-Legierung bestehen. Bei der zweiten metallischen Schicht handelt es sich bevorzugt um einen Zinklegierungsüberzug (Zn-Y). Dieser entsteht, wenn auf die erste metallische Schicht ein Metall aufgetragen wird, das mit der ersten Zn-haltigen Schicht eine Zn-Legierung bildet. Die zweite metallische Schicht ist bevorzugt aus mindestens einem der Elemente aus der Gruppe Mg, Al, Ti, Cr, Mn, Ni oder deren Legierungen gebildet. Die Wärmebehandlung wird vor oder nach dem Auftragen der Plasmapolymerschicht durchgeführt, und zwar bevorzugt bei Temperaturen, die unterhalb von 500°C liegen.

Die WO 2009/010473 A2 offenbart ein Verfahren zum Herstellen eines mit einem Korrosionsschutzsystem beschichteten Stahlblechs, bei dem auf ein die Grundschicht des Stahlblechs bildendes Stahlsubstrat eine erste metallische Schicht aufgebracht wird, die auf Nickel und Molybdän basiert. Auf die erste metallische Schicht wird anschließend eine zweite metallische Schicht aufgebracht, die auf Chrom basiert. Auf die zweite metallische Schicht wird dann eine dritte metallische Schicht aus Kupfer aufgebracht. Danach wird das so beschichtete Stahlblech einer Wärmebehandlung unterworfen.

Die Dokumente JP H07 310167 A, EP 1 900 854 A1, US 2 402 834 A und GB 303 034 A beschreiben ebenfalls Verfahren zum Herstellen eines mit einem Korrosionsschutzsystem beschichteten Stahlblechs.

Bei dem in JP H07 310167 A beschriebenen Verfahren werden auf mindestens eine Seite eines Stahlblechs, das Niob und weniger als 0,003 Gew.-% Kohlenstoff enthält, eine 0,1 bis 1 µm dicke Schicht aus Chrom und eine 1 bis 8 µm dicke Schicht aus Nickel aufgebracht. Anschließend wird das Stahlblech erhitzt, so dass die beiden Schichten ineinander diffundieren.

Die EP 1 900 854 A1 offenbart ein Verfahren zur Beschichtung eines Stahlsubstrats, insbesondere Stahlbandes, mit einer Diffusionsschicht, bei dem die Diffusionsschicht durch galvanische Abscheidung einer Chromschicht auf wenigstens einer auf dem Substrat angeordneten metallischen Zwischenschicht und nachfolgender thermischer Behandlung gebildet wird.

Die US 2 402 834 A beschreibt die Beschichtung eines Stahlsubstrats, welches zunächst mit einer Chromschicht, dann mit einer Nickelschicht, anschließend erneut mit einer Chromschicht und danach erneut mit einer Nickelschicht galvanisiert wird. Anschließend wird das so beschichtete Stahlsubstrat bei einer Temperatur von 1100°F bis 2500°F (also ca. 593,33°C bis 1371,11°C) über einen Zeitraum von mindestens 5 Stunden erhitzt, wodurch sich eine teilweise Legierung der Metallschichten mit der Grundschicht und untereinander bildet. Anschließend wird das so behandelte Stahlsubstrat kaltgewalzt und erneut auf eine Temperatur von 1100°F bis 2500°F erhitzt, so dass eine vollständige Diffusion des Chroms, des Nickels und des Eisens sichergestellt ist.

Die GB 303 034 A beschreibt ein Verfahren zum Herstellen von hitzebeständigen, porenfreien Beschichtungen aus Chrom oder Kobalt auf Stahlsubstraten, bei dem ein drittes Metall, welches zu einer Nickel, Chrom und Kobalt umfassenden Gruppe gehört, als Diffusionsmittel vor dem Beschichtungsmetall auf das Stahlsubstrat aufgebracht wird. Anschließend wird das beschichtete Stahlsubstrat auf eine Temperatur im Bereich von 1100°C bis 1300°C erhitzt, um die Diffusion der Metalle zu bewirken.

Davon ausgehend lag der Erfindung die Aufgabe zugrunde, ein Verfahren zur Herstellung von Stahlblech aus unlegiertem oder niedriglegiertem Kohlenstoffstahl zu schaffen, das rost- und säurebeständige Oberflächeneigenschaften aufweist, die insbesondere eine hohe Beständigkeit in chloridhaltigen Medien und/oder Säuren bietet. Dabei sollte insbesondere eine deutlich günstigere Lösung als die bekannten rost-und säurebeständigen Stähle, die im Vollmaterial Chrom- und Nickelanteile von über 10 Gew.-% aufweisen, geboten werden. Vorzugsweise sollte das Stahlblech dabei ohne farbgebende organische Lackbeschichtung auskommen, hinsichtlich seiner ästhetischen Wirkung einen hochwertigen Eindruck vermitteln und eine sehr hohe UV-Beständigkeit aufweisen.

Erfindungsgemäß wird diese Aufgabe durch ein Verfahren mit den in Anspruch 1 angegebenen Merkmalen gelöst.

Die Erfindung liegt somit in einem Verfahren zum Herstellen eines mit einem Korrosionsschutzsystem beschichteten Stahlblechs, bei dem auf ein die Grundschicht des Stahlblechs bildendes Stahlsubstrat aus einem Stahl mit einem Kohlenstoffgehalt von bis zu 2,1 Gew.-%, einem Chromgehalt von bis zu 0,4 Gew.-% und einem Nickelgehalt von bis zu 0,4 Gew.-% mindestens eine erste metallische Schicht und auf die mindestens eine erste metallische Schicht mindestens eine zweite metallische Schicht aufgetragen wird, die in Folge mindestens einer zwischengeordneten Wärmebehandlung mit der mindestens einen ersten metallischen Schicht eine metallische Legierung bildet, wobei die mindestens eine erste metallische Schicht hauptsächlich auf Nickel und die mindestens eine zweite Schicht hauptsächlich auf Chrom basiert oder wobei die mindestens eine erste Schicht hauptsächlich auf Chrom und die mindestens eine zweite metallische Schicht hauptsächlich auf Nickel basiert, wobei die zwischengeordnete Wärmebehandlung des beschichteten Stahlsubstrats unter Schutzgasatmosphäre oder Vakuum bei Temperaturen, die oberhalb von 650°C, vorzugsweise oberhalb von 680°C liegen, durchgeführt wird, so dass sich durch Diffusion die metallische Legierung ausbildet, die Eisen, Nickel und Chrom enthält, wobei auf die mindestens eine zweite metallische Schicht mindestens eine dritte metallische Schicht aufgebracht wird, die mit der mindestens einen ersten metallischen Schicht und der mindestens einen zweiten metallischen Schicht eine metallische Legierung bildet, wobei die mindestens eine dritte metallische Schicht auf mindestens einem Element aus der Gruppe Mn, V, Ti, Nb, Mo, Cu, Al, W, Si, B, C und/oder N basiert und wobei das mit der mindestens einen zweiten metallischen Schicht beschichtete Stahlsubstrat nach dem Aufbringen der mindestens einen dritten metallischen Schicht einer zusätzlichen Wärmebehandlung unter Schutzgasatmosphäre oder Vakuum bei Temperaturen, die oberhalb von 650°C, vorzugsweise oberhalb von 680°C liegen, unterworfen wird.

Die Wärmebehandlung (Glühbehandlung) dient der Einstellung von metallischen Phasen der Elemente Cr, Ni, Fe sowie gegebenenfalls weiterer Elemente, die den typischen rost- und säurebeständigen austenitischen Stahlgüten (z.B. 18Cr-8Ni-Fe) ähnlich sind und entsprechende Eigenschaften aufweisen. Die Temperaturobergrenze der Wärmebehandlung liegt beispielsweise bei ca. 1200°C. Die Dauer der jeweiligen Glühbehandlung liegt zum Beispiel im Bereich von 10 bis 3600 Sekunden in Anlehnung an einen kontinuierlichen Glühprozess. Alternativ kann die Dauer der Glühung aber auch in Anlehnung an einen diskontinuierlichen Haubenglühprozess zwischen 4 und 48 Stunden betragen.

Als Schutzgas wird bei dem erfindungsgemäßen Verfahren vorzugsweise sogenanntes Formiergas verwendet. Dabei handelt es sich um ein leicht reduzierend wirkendes Gasgemisch aus Stickstoff (N₂) und Wasserstoff (H₂). Ein geeignetes Formiergas enthält mindestens 5% Wasserstoff, vorzugsweise aber mehr als 50% Wasserstoff (der Rest des Formiergases besteht aus Stickstoff), und besitzt einen Taupunkt von -30°C oder weniger. Der enthaltene Wasserstoff wirkt reduzierend auf Metalloxide und verhindert eine Oxidation.

Die mindestens eine erste metallische Schicht, welche auf Nickel basiert, wird vorzugsweise durch elektrogalvanische Abscheidung oder physikalische Gasphasenabscheidung auf das Stahlsubstrat aufgetragen. Die mindestens eine zweite metallische Schicht, welche auf Chrom basiert, kann ebenfalls durch elektrogalvanische Abscheidung oder physikalische Gasphasenabscheidung aufgebracht werden. Vorzugsweise wird allerdings die zweite metallische Schicht durch physikalische Gasphasenabscheidung aufgebracht, wenn die erste metallische Schicht zuvor durch elektrogalvanische Abscheidung aufgetragen wird, oder umgekehrt durch elektrogalvanische Abscheidung auf die erste metallische Schicht aufgebracht, wenn diese zuvor durch physikalische Gasphasenabscheidung aufgetragen wurde.

Die Dicke der (mindestens einen) ersten metallischen Schicht, welche auf Nickel basiert, liegt vorzugsweise im Bereich von 100 - 10.000 nm, insbesondere im Bereich von 100 - 1.000 nm. Die Dicke der (mindestens einen) zweiten metallischen Schicht, welche auf Chrom basiert, ist dagegen vorzugsweise größer; sie liegt beispielsweise im Bereich von 200 - 20.000 nm, insbesondere im Bereich von 200 - 2.000 nm.

Der metallische Überzug bzw. das Korrosionsschutzsystem des erfindungsgemäßen Stahlflachprodukts ist nach einer bevorzugten Ausgestaltung der Erfindung im Wesentlichen frei von Zink, d.h. er enthält kein Zink bis auf unvermeidbare Zinkverunreinigungen. Hierdurch kann die Verschweißbarkeit des erfindungsgemäß hergestellten Stahlblechs verbessert werden.

Der metallische Überzug bzw. das Korrosionsschutzsystem des erfindungsgemäß hergestellten Stahlblechs enthält mindestens eines der Elemente aus der Gruppe Mn, V, Ti, Nb, Mo, Cu, Al, W, Si, B, C und N oder eine aus mehreren dieser Elemente gebildete Legierung. Durch das Applizieren bzw. Einlegieren eines oder mehrerer dieser Elemente können spezielle Korrosionsschutzeigenschaften verbessert oder weiter optimiert werden. Zum Beispiel kann durch das Applizieren bzw. Einlegieren von Molybdän die Lochfraßbeständigkeit in chloridhaltigen Medien verbessert werden. Ferner kann zum Beispiel durch das Applizieren bzw. Einlegieren von Aluminium die Beständigkeit gegen Hochtemperaturoxidation verbessert werden. Des Weiteren kann zum Beispiel durch das Applizieren bzw. Einlegieren von Titan und/oder Wolfram die Temperaturbeständigkeit des Stahlflachproduktes bzw. seines Korrosionsschutzüberzuges verbessert werden.

Eine weitere vorteilhafte Ausgestaltung des erfindungsgemäßen Verfahrens sieht vor, dass die Wärmebehandlung bzw. eine Glühbehandlung nach jedem der Beschichtungsschritte erfolgt. Hierdurch kann der Diffusionsprozess bzw. können die Diffusionsprozesse beschleunigt und eine größere (stärkere) Durchmischung erzielt werden. Eine Variante des erfindungsgemäßen Verfahrens ist dementsprechend dadurch gekennzeichnet, dass das mit der mindestens einen ersten metallischen Schicht beschichtete Stahlsubstrat vor dem Aufbringen der mindestens einen zweiten metallischen Schicht einer zwischengeordneten Wärmebehandlung unter Schutzgasatmosphäre oder Vakuum bei Temperaturen, die oberhalb von 650°C, vorzugsweise oberhalb von 680°C liegen, unterworfen wird.
Eine weitere vorteilhafte Ausgestaltung der Erfindung ist dadurch gekennzeichnet, dass die mindestens eine erste metallische Schicht und/oder die mindestens eine zweite metallische Schicht und gegebenenfalls auch die mindestens eine dritte metallische Schicht mehrfach aufgebracht werden, um eine Mehrfachlagenbeschichtung zu realisieren. Hierdurch, also durch das mehrfach wiederholte Aufbringen mindestens einer, zweier oder aller dieser Schichten, kann nach der abschließenden Wärmebehandlung (Glühbehandlung) im Anschluss an das Aufbringen der mehreren metallischen Schichten oder alternativ bei Anwendung einer Glühbehandlung nach jeder der Beschichtungsschritte (Zwischenglühungen) ein Stahlflachprodukt aus unlegiertem oder niedriglegiertem Kohlenstoff-Stahl mit einem besonders dichten und stabilen Korrosionsschutzsystem erzielt werden.

Eine weitere Ausgestaltung des erfindungsgemäßen Verfahrens besteht darin, dass das mit einer der metallischen Schichten beschichtete Stahlsubstrat vor dem Aufbringen einer weiteren der metallischen Schichten gereinigt wird, vorzugsweise in einem Vakuumprozess mittels Argon-Plasma gereinigt wird. Die Reinigung dient dem Entfernen eventuell auf der Oberfläche der Beschichtung vorhandener Kontaminationen bzw. Oxide, die beim Aufwachsen der nachfolgenden Beschichtung stören können.

Nachfolgend wird die Erfindung anhand von Ausführungsbeispielen mit Bezug auf die beiliegenden Abbildungen und Tabellen näher erläutert.

### Beispiel 1

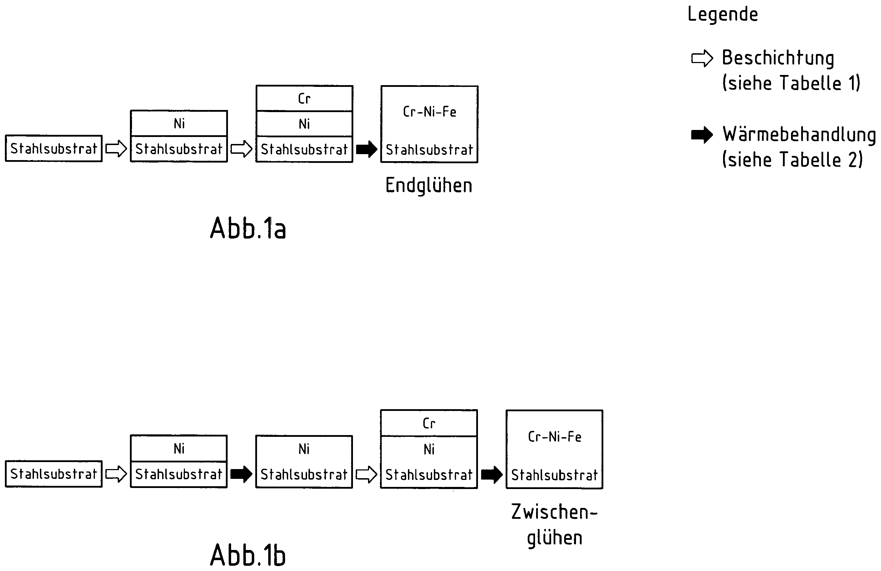

Ein Stahlsubstrat aus unlegiertem oder niedriglegiertem Kohlenstoffstahl in Form eines warm- oder kaltgewalzten Stahlfeinblechs wurde mit einer ca. 500 nm dicken Nickelbeschichtung versehen (vgl. Abb. 1a). Die Nickelbeschichtung wurde durch elektrogalvanische Abscheidung unter Verwendung eines schwefelsauren und Nickelsalze enthaltenden wässrigen Elektrolyten erzeugt. Anschließend wurde die Oberfläche des beschichteten Stahlsubstrats (Stahlfeinblechs) in einem Vakuumprozess mittels Argon-Plasma gereinigt. Unmittelbar im Anschluss daran wurde in einem Vakuumbeschichtungsprozess eine Chrombeschichtung mit einer Dicke von ca. 1000 nm auf die Nickelschicht appliziert, so dass ein zweilagiger metallischer Überzug (Schichtverbund) erhalten wurde.

Die Reinigung im Vakuum erfolgte mittels Ar-Ionen. Dabei wurde in diesem Beispiel die Probenoberfläche bei einem Argon-Prozessdruck von 1*10⁻³ mbar über einen Zeitraum von 150s dem Beschuss von hochenergetischen Ar-Ionen ausgesetzt. Dies diente dem Abtrag eventuell auf der Oberfläche vorhandener Kontaminationen bzw. Oxide, die beim Aufwachsen der nachfolgenden Beschichtung stören könnten.

Die Vakuumbeschichtung ist in diesem Fall eine PVD-Beschichtung (physikalische Gasphasenabscheidung) mittels Elektronenstrahlverdampfen von metallischem Chrom, welche bei einem Prozessdruck kleiner 1*10⁻⁵ mbar und einer Abscheiderate von mindestens 2,5 nm/s durchgeführt wurde.

Das auf diese Weise beschichtete Stahlsubstrat (Stahlfeinblech) wurde nachfolgend einer kontinuierlichen Glühbehandlung in einer Formiergasatmosphäre zugeführt und ca. 2 Minuten bei einer Zieltemperatur von ca. 1.000°C geglüht. Anschließend wurde das so geglühte Stahlsubstrat unter der Formiergasatmosphäre auf Raumtemperatur abgekühlt. Das Formiergas enthielt zwischen 50% und 95% Stickstoff und zwischen 50% bzw. 5% Wasserstoff und hatte einen Taupunkt von -40°C.

Im Ergebnis stellte sich an der Oberfläche des beschichteten Stahlsubstrats eine Diffusionsschicht ein, welche die Legierungselemente (Legierungspartner) Eisen, Nickel und Chrom enthält. Je nach weiteren Begleit- und/oder Legierungselementen des Stahlsubstrats, wie beispielsweise Mn, V, Ti, Nb, Mo, Cu, Al, Si, B, C oder N, sind diese mitunter ebenfalls in der Diffusionsschicht wiederzufinden (vgl. Fig. 1a und Tabellen 1 und 2).

### Beispiel 2

Wie im Beispiel 1 wurde ein Stahlsubstrat (Stahlfeinblech) aus unlegiertem oder niedriglegiertem Kohlenstoffstahl mit einer ca. 500 nm dicken Nickelbeschichtung versehen. Die Nickelbeschichtung wurde wiederum elektrolytisch durch elektrogalvanische Abscheidung unter Verwendung eines schwefelsauren und Nickelsalze enthaltenden wässrigen Elektrolyten erzeugt (vgl. Abb. 1b). Im Unterschied zu dem Herstellungsprozess gemäß Beispiel 1 (Abb. 1a) wurde jedoch bereits das mit der Nickelschicht versehene Stahlsubstrat einer kontinuierlichen Glühbehandlung zugeführt.

Anschließend wurde die Oberfläche des mit Nickel beschichteten Stahlsubstrats in einem Vakuumprozess mittels Argon-Plasma gereinigt. Unmittelbar im Anschluss daran wurde in einem Vakuumbeschichtungsprozess eine Chrombeschichtung mit einer Dicke von ca. 1000 nm auf die Nickelschicht appliziert, so dass ein zweilagiger metallischer Überzug erhalten wurde.

Die Vakuumbeschichtung ist auch in diesem Fall eine PVD-Beschichtung mittels Elektronenstrahlverdampfen von metallischem Chrom, welche bei einem Prozessdruck kleiner 1*10⁻⁵ mbar und einer Abscheiderate von mindestens 2,5 nm/s durchgeführt wurde.

Das so beschichtete Stahlsubstrat wurde nachfolgend einer weiteren kontinuierlichen Glühbehandlung zugeführt. Die jeweilige Glühbehandlung erfolgte mit einer Zieltemperatur von ca. 1.000°C in einer Formiergasatmosphäre. Das Formiergas enthielt zwischen 50% und 95% Stickstoff und zwischen 50% bzw. 5% Wasserstoff und hatte einen Taupunkt von -40°C. Die Gesamtdauer der Glühbehandlungen lag im Bereich von ca. 3 bis 4 Minuten.

Durch das Zwischenglühen des mit Nickel beschichteten Stahlsubstrats vor dem abschließenden Glühen nach dem Aufbringen der Chrombeschichtung lassen sich die Diffusionsprozesse beschleunigen und eine bessere Durchmischung der Legierungspartner Eisen, Nickel und Chrom in der Diffusionsschicht erzielen.

Je nach weiteren Begleit- und/oder Legierungselementen des Stahlsubstrats, wie beispielsweise Mn, V, Ti, Nb, Mo, Cu, Al, Si, B, C oder N, sind diese mitunter ebenfalls in der Diffusionsschicht wiederzufinden (vgl. Fig. 1b und Tabellen 1 und 2).

### Beispiel 3

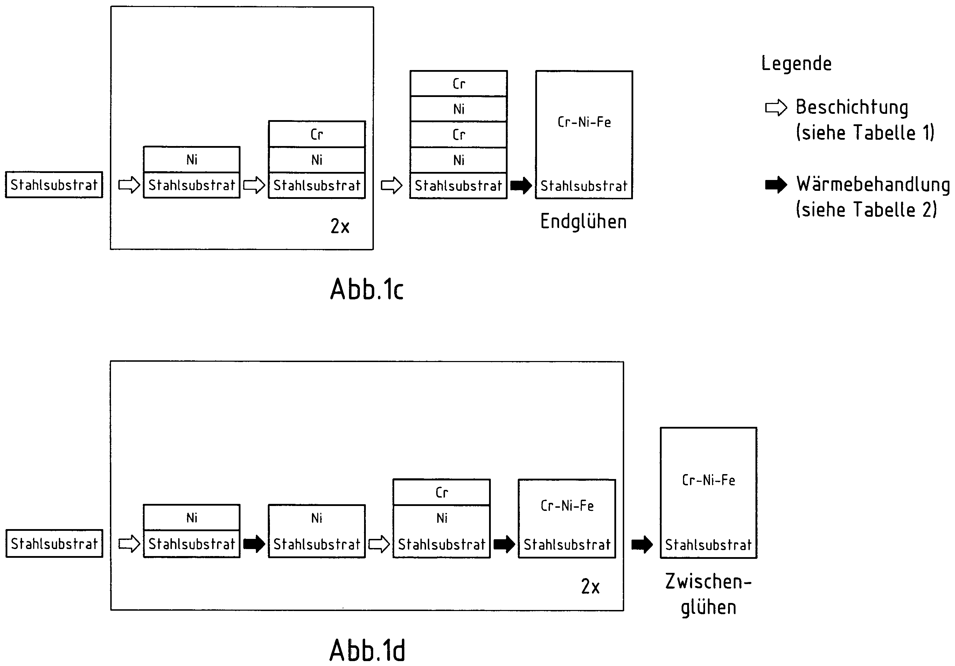

Die in Abb. 1c skizzierte Variante des erfindungsgemäßen Herstellungsverfahrens unterscheidet sich von dem Beispiel gemäß Abb. 1a dadurch, dass das Auftragen einer Nickelschicht und das anschließende Aufbringen einer Chromschicht wiederholt wurden, also mindestens zweimal durchgeführt wurden (vgl. Abb. 1c). Auf diese Weise wurde eine Mehrlagenbeschichtung realisiert. Zwischen den einzelnen Beschichtungsschritten erfolgte jeweils eine Reinigung der Beschichtungsoberfläche im Vakuum mittels Ar-Ionen.

Das so beschichtete Stahlsubstrat wurde nachfolgend einer kontinuierlichen Glühbehandlung zugeführt. Die Glühbehandlung erfolgte mit einer Zieltemperatur von ca. 1.000 °C in einer Formiergasatmosphäre. Das Formiergas enthielt zwischen 50% und 95% Stickstoff und zwischen 50% bzw. 5% Wasserstoff und hatte einen Taupunkt von - 40°C. Die Dauer der Glühbehandlung lag im Bereich von ca. 2 bis 3 Minuten.

Im Ergebnis stellte sich an der Oberfläche des beschichteten Stahlsubstrats wiederum eine Diffusionsschicht ein, welche die Legierungselemente Eisen, Nickel und Chrom enthält. Je nach weiteren Begleit- und/oder Legierungselementen des Stahlsubstrats, wie beispielsweise Mn, V, Ti, Nb, Mo, Cu, Al, Si, B, C oder N, sind diese mitunter ebenfalls in der Diffusionsschicht wiederzufinden (vgl. Fig. 1c und Tabellen 1 und 2).

### Beispiel 4

In Abb. 1d ist eine weitere Variante des erfindungsgemäßen Herstellungsverfahrens skizziert. Diese Variante unterscheidet sich von dem Beispiel gemäß Abb. 1b im Wesentlichen dadurch, dass das Auftragen einer Nickelschicht, das Zwischenglühen des mit Nickel beschichteten Stahlsubstrats, das anschließende Aufbringen einer Chromschicht sowie das Glühen des so beschichteten Stahlsubstrats wiederholt wurden, also mindestens zweimal durchgeführt wurden (vgl. Abb. 1d und Tabellen 1 und 2). Zwischen den Beschichtungsschritten erfolgte jeweils eine Reinigung der Beschichtungsoberfläche im Vakuum mittels Ar-Ionen.

Auf diese Weise wurde eine Mehrlagenbeschichtung realisiert, die nach der abschließenden Glühbehandlung mit einer Zieltemperatur von ca. 1.000 °C in einer Formiergasatmosphäre besonders dicht und stabil ist.

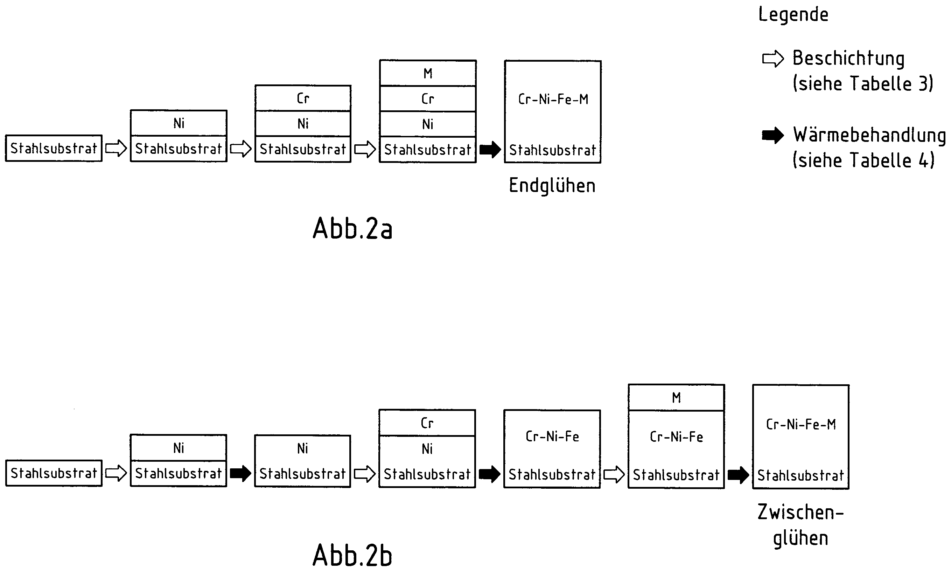

Weitere Varianten des erfindungsgemäßen Herstellungsverfahrens sind in den Abbildungen 2a bis 2d skizziert. Diesen Varianten haben gemein, dass außer Nickel und Chrom ein oder mehrere zusätzliche Metalle, wie zum Beispiel Molybdän, Titan, Aluminium und/oder Wolfram auf das Stahlsubstrat appliziert wurden, um spezielle Korrosionsschutzeigenschaften besonders zu optimieren.

Die in Abb. 2a bis 2d skizzierten Varianten des erfindungsgemäßen Herstellungsverfahrens unterscheiden sich von den in den Abb. 1a bis 1d skizzierten Beispielen dadurch, dass auf die (mindestens eine) zweite metallische Schicht des metallischen Überzuges, bei der es sich um eine Chrombeschichtung handelt, mindestens eine dritte metallische Schicht aufgebracht wird, die mindestens eines der Elemente aus der Gruppe Mo, Ti, Al, W, Mn, V, Nb, Cu, Si, B, C und N oder eine aus mehreren dieser Elemente gebildete Legierung enthält. Die dritte metallische Schicht ist in den Abbildungen 2a bis 2d mit M bezeichnet. Sie wird in dem erfindungsgemäßen Herstellungsverfahren vorzugsweise mittels physikalischer Gasphasenabscheidung aufgetragen. Ihre Dicke wird vorzugsweise deutlich geringer eingestellt als die jeweilige Dicke der Nickelschicht bzw. der Chromschicht. Die Dicke der dritten metallischen Schicht (M) liegt beispielsweise im Bereich von 20-2000 nm, vorzugsweise im Bereich von 20-400 nm (vgl. Abb. 2a und Tabellen 3 und 4).

### Beispiel 5

Die Variante gemäß Abb. 2a unterscheidet sich von dem in Abb. 1a skizzierten Beispiel dadurch, dass auf die zweite Schicht des metallischen Überzuges, bei der es sich um eine Chrombeschichtung handelt, eine dritte metallische Schicht M aufgebracht wurde, die beispielsweise mindestens eines der Elemente aus der Gruppe Mo, Ti, Al und W enthält. Zwischen den Beschichtungsschritten erfolgte jeweils eine Reinigung der Beschichtungsoberfläche im Vakuum mittels Ar-Ionen.

Das gemäß Abb. 2a beschichtete Stahlsubstrat (Stahlfeinblech) wurde einer Glühbehandlung in einer Formiergasatmosphäre zugeführt, dort ca. 2 Minuten bei einer Zieltemperatur von ca. 1.000°C kontinuierlich geglüht und im Anschluss unter der Formiergasatmosphäre auf Raumtemperatur abgekühlt.

### Beispiel 6

Die Variante gemäß Abb. 2b unterscheidet sich von dem in Abb. 1b skizzierten Beispiel dadurch, dass auf das mit der Nickelschicht und der Chromschicht versehene und nach jedem Beschichtungsschritt in einer Formiergasatmosphäre bei einer Zieltemperatur von ca. 1.000°C kontinuierlich geglühte Stahlsubstrat eine dritte metallische Schicht M aufgebracht wurde, die beispielsweise mindestens eines der Elemente aus der Gruppe Mo, Ti, Al und W enthält. Zwischen den Beschichtungsschritten erfolgte jeweils eine Reinigung der Beschichtungsoberfläche im Vakuum mittels Ar-Ionen (vgl. Abb. 2b und Tabellen 3 und 4).

### Beispiel 7

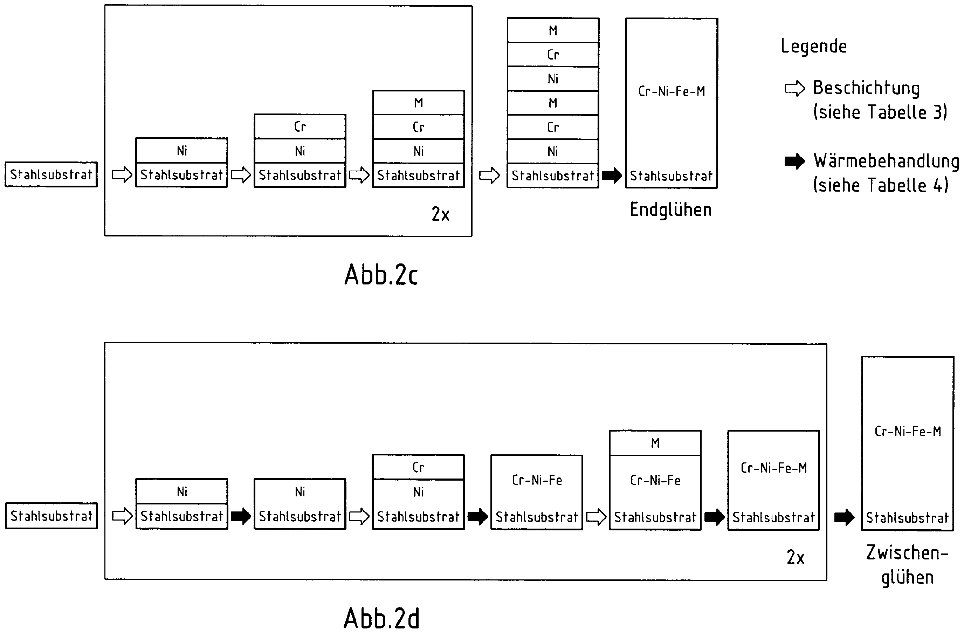

Die Variante gemäß Abb. 2c unterscheidet sich von dem in Abb. 2a skizzierten Beispiel dadurch, dass das Auftragen einer Nickelschicht, das anschließende Aufbringen einer Chromschicht und das zusätzliche Aufbringen einer dritten metallischen Schicht, die beispielsweise mindestens eines der Elemente aus der Gruppe Mo, Ti, Al und W enthält, wiederholt wurden, so dass ein 6-lagiger metallischer Überzug erzeugt wurde. Zwischen den einzelnen Beschichtungsschritten erfolgte jeweils eine Reinigung der Beschichtungsoberfläche im Vakuum mittels Ar-Ionen. Das so beschichtete Stahlsubstrat wurde schließlich einer kontinuierlichen Glühbehandlung zugeführt, die derjenigen des Beispiels 5 (Abb. 2a) entsprach.

### Beispiel 8

Die Variante gemäß Abb. 2d unterscheidet sich von dem in Abb. 2b skizzierten Beispiel dadurch, dass das Aufbringen der verschiedenen metallischen Schichten sowie die Wärmebehandlung (Zwischenglühen) des Stahlsubstrats nach jedem Beschichtungsschritt wiederholt wurden, so dass auf dem Stahlsubstrat ein 6-lagiger metallischer Überzug erzeugt wurde. Zwischen den einzelnen Beschichtungsschritten erfolgte jeweils eine Reinigung der Beschichtungsoberfläche im Vakuum mittels Ar-Ionen. Abschließend erfolgte nochmals eine kontinuierliche Wärmebehandlung (Glühen) des beschichteten Stahlsubstrats in einer Formiergasatmosphäre bei einer Zieltemperatur von ca. 1.000°C für eine Dauer von ca. 2 Minuten.

**Tabelle 1) Schicht applikation**

| Abb. | Material | Verfahren | Schichtdicke [nm] |
|---|---|---|---|
| 1a | Ni | elektolytisch | 100-10.000 |
| | Cr | PVD (e-beam, Magnetronsputtern, thermisch, Bogenverdampfung) | 200-20.000 |
| 1b | Ni | elektolytisch | 100-10.000 |
| | Cr | PVD (e-beam, Magnetronsputtern, thermisch, Bogenverdampfung) | 200-20.000 |
| 1c | Ni | elektolytisch | 100-10.000 |
| | Cr | PVD (e-beam, Magnetronsputtern, thermisch, Bogenverdampfung) | 200-20.000 |
| 1d | Ni | elektolytisch | 100-10.000 |
| | Cr | PVD (e-beam, Magnetronsputtern, thermisch, Bogenverdampfung) | 200-20.000 |

**Tabelle 2) Glühparameter)***

| Abb. | Temperatur | Atmosphäre | Dauer |
|---|---|---|---|
| 1a | 700-1200°C | 1.0-100% H2; (100-0)%N2; | 10s-3600s |
| | | 2. Vakuum | |
| 1b | 700-1200°C | 1.0-100% H2; (100-0)%N2; | 10s-3600s |
| | | 2. Vakuum | |
| | 700-1200°C | 1.0-100% H2; (100-0)%N2; | 10s-3600s |
| | | 2. Vakuum | |
| 1c | 700-1200°C | 1.0-100% H2; (100-0)%N2; | 10s-3600s |
| | | 2. Vakuum | |
| 1d | 700-1200°C | 1.0-100% H2; (100-0)%N2; | 10s-3600s |
| | | 2. Vakuum | |
| | 700-1200°C | 1.0-100% H2; (100-0)%N2; | 10s-3600s |
| | | 2. Vakuum | |
| | 700-1200°C | 1.0-100% H2; (100-0)%N2; | 10s-3600s |
| | | 2. Vakuum | |
| | 700-1200°C | 1.0-100% H2; (100-0)%N2; | 10s-3600s |
| | | 2. Vakuum | |

| | | | |
|---|---|---|---|
| )* Aufgelöst nach den insgesamt durchgeführten Glühschritten (siehe Fertigungsschema); Die einzelnen Glühschritte können auch individuell angepaßt werden | | | |

**Tabelle 3) Schicht applikation**

| Abb. | Material | Verfahren | Schichtdicke [nm] |
|---|---|---|---|
| 2a | Ni | PVD (s.o.) | 100-10.000 |
| | Cr | elektolytisch | 200-20.000 |
| | M (z.B. Mo.Ti.Al.W) | PVD (s.o.) | 20-2.000 |
| 2b | Ni | PVD (s.o.) | 100-10.000 |
| | Cr | elektolytisch | 200-20.000 |
| | M (z.B. Mo,Ti,Al,W) | PVD (s.o.) | 20-2.000 |
| 2c | Ni | PVD (s.o.) | 100-10.000 |
| | Cr | elektolytisch | 200-20.000 |
| | M (z.B. Mo,Ti,Al,W) | PVD (s.o.) | 20-2.000 |
| 2d | Ni | PVD (s.o.) | 100-10.000 |
| | Cr | elektolytisch | 200-20.000 |
| | M (z.B. Mo.Ti.Al.W) | PVD (s.o.) | 20-2.000 |

**Tabelle 4) Glühparameter)***

| Abb. | Temperatur | Atmosphäre | Dauer |
|---|---|---|---|
| 2a | 700-1200°C | 1.0-100% H2; (100-0)%N2; | 10s-3600s |
| | | 2. Vakuum | |
| 2b | 700-1200°C | 1.0-100% H2; (100-0)%N2; | 10s-3600s |
| | | 2. Vakuum | |
| | 700-1200°C | 1.0-100% H2; (100-0)%N2; | 10s-3600s |
| | | 2. Vakuum | |
| | 700-1200°C | 1.0-100% H2; (100-0)%N2; | 10s-3600s |
| | | 2. Vakuum | |
| 2c | 700-1200°C | 1.0-100% H2; (100-0)%N2; | 10s-3600s |
| | | 2. Vakuum | |
| 2d | 700-1200°C | 1.0-100% H2; (100-0)%N2; | 10s-3600s |
| | | 2. Vakuum | |
| | 700-1200°C | 1.0-100% H2; (100-0)%N2; | 10s-3600s |
| | | 2. Vakuum | |
| | 700-1200°C | 1.0-100% H2; (100-0)%N2; | 10s-3600s |
| | | 2. Vakuum | |
| | 700-1200°C | 1.0-100% H2; (100-0)%N2; | 10s-3600s |
| | | 2. Vakuum | |
| | 700-1200°C | 1.0-100% H2; (100-0)%N2; | 10s-3600s |
| | | 2. Vakuum | |
| | 700-1200°C | 1.0-100% H2; (100-0)%N2; | 10s-3600s |
| | | 2. Vakuum | |

| | | | |
|---|---|---|---|
| )* Aufgelöst nach den insgesamt durchgeführten Glühschritten (siehe Fertigungsschema); Die einzelnen Glühschritte können auch individuell angepaßt werden | | | |

## Patentansprüche

1. Verfahren zum Herstellen eines mit einem Korrosionsschutzsystem beschichteten Stahlblechs, bei dem auf ein die Grundschicht des Stahlblechs bildendes Stahlsubstrat aus einem Stahl mit einem Kohlenstoffgehalt von bis zu 2,1 Gew.-%, einem Chromgehalt von bis zu 0,4 Gew.-% und einem Nickelgehalt von bis zu 0,4 Gew.-% mindestens eine erste metallische Schicht und auf die mindestens eine erste metallische Schicht mindestens eine zweite metallische Schicht aufgetragen wird, die in Folge mindestens einer zwischengeordneten Wärmebehandlung mit der mindestens einen ersten metallischen Schicht eine metallische Legierung bildet, wobei die mindestens eine erste metallische Schicht hauptsächlich auf Nickel und die mindestens eine zweite Schicht hauptsächlich auf Chrom basiert oder wobei die mindestens eine erste Schicht hauptsächlich auf Chrom und die mindestens eine zweite metallische Schicht hauptsächlich auf Nickel basiert, wobei die zwischengeordnete Wärmebehandlung des beschichteten Stahlsubstrats unter Schutzgasatmosphäre oder Vakuum bei Temperaturen, die oberhalb von 650°C, vorzugsweise oberhalb von 680°C liegen, durchgeführt wird, so dass sich durch Diffusion die metallische Legierung ausbildet, die Eisen, Nickel und Chrom enthält, wobei auf die mindestens eine zweite metallische Schicht mindestens eine dritte metallische Schicht aufgebracht wird, die mit der mindestens einen ersten metallischen Schicht und der mindestens einen zweiten metallischen Schicht eine metallische Legierung bildet, wobei die mindestens eine dritte metallische Schicht auf mindestens einem Element aus der Gruppe Mn, V, Ti, Nb, Mo, Cu, Al, W, Si, B, C und/oder N basiert und wobei das mit der mindestens einen zweiten metallischen Schicht beschichtete Stahlsubstrat nach dem Aufbringen der mindestens einen dritten metallischen Schicht einer zusätzlichen Wärmebehandlung unter Schutzgasatmosphäre oder Vakuum bei Temperaturen, die oberhalb von 650°C, vorzugsweise oberhalb von 680°C liegen, unterworfen wird.

2. Verfahren nach Anspruch 1, **dadurch gekennzeichnet, dass** das Korrosionsschutzsystem bis auf unvermeidbare Verunreinigungen frei von Zink ist.

3. Verfahren nach Anspruch 1 oder 2, **dadurch gekennzeichnet, dass** die mindestens eine erste metallische Schicht durch elektrogalvanische Abscheidung oder physikalische Gasphasenabscheidung auf das Stahlsubstrat aufgetragen wird.

4. Verfahren nach einem der Ansprüche 1 bis 3, **dadurch gekennzeichnet, dass** die mindestens eine zweite metallische Schicht durch elektrogalvanische Abscheidung oder physikalische Gasphasenabscheidung auf die mindestens eine erste metallische Schicht aufgebracht wird.

5. Verfahren nach einem der Ansprüche 1 bis 4, **dadurch gekennzeichnet, dass** das mit der mindestens einen ersten metallischen Schicht beschichtete Stahlsubstrat vor dem Aufbringen der mindestens einen zweiten metallischen Schicht einer zwischengeordneten Wärmebehandlung unter Schutzgasatmosphäre oder Vakuum bei Temperaturen, die oberhalb von 650°C, vorzugsweise oberhalb von 680°C liegen, unterworfen wird.

6. Verfahren nach einem der Ansprüche 1 bis 5, **dadurch gekennzeichnet, dass** die mindestens eine dritte metallische Schicht durch elektrogalvanische Abscheidung oder physikalische Gasphasenabscheidung auf die mindestens eine zweite metallische Schicht aufgebracht wird.

7. Verfahren nach einem der Ansprüche 1 bis 6, **dadurch gekennzeichnet, dass** die mindestens eine erste metallische Schicht und/oder die mindestens eine zweite metallische Schicht mehrfach aufgebracht werden, um eine Mehrfachlagenbeschichtung zu realisieren.

8. Verfahren nach einem der Ansprüche 1 bis 7, **dadurch gekennzeichnet, dass** die mindestens eine dritte metallische Schicht mehrfach aufgebracht wird, um eine Mehrfachlagenbeschichtung zu realisieren.

9. Verfahren nach einem der Ansprüche 1 bis 8, **dadurch gekennzeichnet, dass** das mit einer der metallischen Schichten beschichtete Stahlsubstrat vor dem Aufbringen einer weiteren der metallischen Schichten gereinigt wird, vorzugsweise in einem Vakuumprozess mittels Argon-Plasma gereinigt wird.

## Claims

1. Method for producing a sheet steel coated with a corrosion protection system, wherein on a steel substrate made of steel with a carbon content of up to 2.1% by weight, a chromium content of up to 0.4% by weight and a nickel content of up to 0.4% by weight forming the base layer of the sheet steel, at least one first metallic layer is coated, and onto said at least one first metallic layer at least one second metallic layer is coated which forms, as a consequence of at least one intermediary heat treatment, a metallic alloy with the at least one first metallic layer, wherein said at least one first metallic layer is predominantly based on nickel and the at least one second layer is predominantly based on chromium, or wherein the at least one first layer is predominantly based on chromium and the at least one second metallic layer is predominantly based on nickel, wherein the intermediary heat treatment of the coated steel substrate is performed under an inert gas atmosphere or vacuum at temperatures above 650°C, preferably above 680°C, such that the metallic alloy containing iron, nickel and chromium is formed by diffusion, wherein onto the at least one second metallic layer at least one third metallic layer is coated which forms a metallic alloy with the at least one first metallic layer and the at least one second metallic layer, wherein the at least one third metallic layer is based on at least one element from the group consisting of Mn, V, Ti, Nb, Mo, Cu, Al, W, Si, B, C, and/or N, and wherein the steel substrate coated with the at least one second metallic layer, after the at least one third metallic layer has been applied, is subjected to an additional heat treatment under an inert gas atmosphere or vacuum at temperatures above 650°C, preferably above 680°C.

2. Method according to claim 1, **characterized in that** that corrosion protection system is free of zinc except for unavoidable impurities.

3. Method according to claim 1 or 2, **characterized in that** the at least one first metallic layer is applied on the steel substrate by electrogalvanic deposition or by physical vapor deposition.

4. Method according to one of claims 1 to 3, **characterized in that** the at least one second metallic layer is applied on the at least one first metallic layer by electrogalvanic deposition or by physical vapor deposition.

5. Method according to one of claims 1 to 4, **characterized in that** the steel substrate coated with the at least one first metallic layer, before applying the at least one second metallic layer, is subjected to an intermediary heat treatment under an inert gas atmosphere or vacuum at temperatures above 650°C, preferably above 680°C.

6. Method according to one of claims 1 to 5, **characterized in that** the at least one third metallic layer is applied on the at least one second metallic layer by electrogalvanic deposition or by physical vapor deposition.

7. Method according to one of claims 1 to 6, **characterized in that** the at least one first metallic layer and/or the at least one second metallic layer are applied several times to realize a coating of multiple layers.

8. Method according to one of claims 1 to 7, **characterized in that** the at least one third metallic layer is applied several times to realize a coating of multiple layers.

9. Method according to one of claims 1 to 8, **characterized in that** the steel substrate coated with one of the metallic layers is cleaned before applying a further one of the metallic layers, preferably cleaned in a vacuum process by means of argon plasma.

## Revendications

1. Procédé de préparation d'une tôle en acier enduite d'un système anticorrosion, dans lequel au moins une première couche métallique est appliquée sur un substrat en acier formant la couche de base de la tôle en acier, le substrat en acier consistant en un acier ayant une teneur en carbone allant jusqu'à 2,1% en poids, une teneur en chrome allant jusqu'à 0,4% en poids et une teneur en nickel allant jusqu'à 0,4% en poids, et au moins une deuxième couche métallique est appliquée sur la première couche métallique, la deuxième couche métallique formant un alliage métallique avec la au moins une première couche métallique par au moins un traitement thermique intermédiaire, où la au moins une première couche métallique se compose essentiellement de nickel et la au moins une deuxième couche se compose essentiellement de chrome, ou où la au moins une première couche métallique se compose essentiellement de chrome et la au moins une deuxième couche se compose essentiellement de nickel, où le traitement thermique intermédiaire du substrat en acier revêtu est réalisé sous atmosphère protectrice ou sous vide, à des températures qui sont supérieures à 650°C, de préférence supérieure à 680°C, de sorte que l'alliage métallique contenant du fer, du nickel et du chrome se forme par diffusion, où au moins une troisième couche métallique est appliquée sur au moins une la deuxième couche métallique, la au moins une troisième couche métallique formant un alliage avec la au moins une première couche métallique et la au moins une deuxième couche métallique, où la au moins une troisième couche métallique se composé d'au moins un élément du groupe Mn, V, Ti, Nb, Mo, Cu, Al, W, Si, B, C et/ou N et où le substrat en acier revêtu de la au moins une deuxième couche métallique est soumis après l'application de la au moins une troisième couche métallique, à un traitement thermique supplémentaire sous atmosphère de gaz protecteur ou sous vide à des températures supérieures à 650°C, de préférence supérieures à 680°C.

2. Procédé selon la revendication 1, **caractérisé en ce que** le système anticorrosion est exempt de zinc, outre les impuretés inévitables.

3. Procédé selon la revendication 1 ou 2, **caractérisé en ce que** la au moins une première couche métallique est appliquée sur le substrat en acier par séparation électro-galvanique ou séparation physique en phase gazeuse.

4. Procédé selon l'une quelconque des revendications 1 à 3, **caractérisé en ce que** la au moins une deuxième couche métallique est appliquée sur la au moins une première couche métallique par séparation électro-galvanique ou séparation physique en phase gazeuse.

5. Procédé selon l'une quelconque des revendications 1 à 4, **caractérisé en ce que** le substrat en acier revêtu de la au moins une première couche métallique est soumis avant l'application de la au moins une deuxième couche métallique, à un traitement thermique intermédiaire sous atmosphère de gaz protecteur ou sous vide à des températures supérieures à 650°C, de préférence supérieures à 680°C..

6. Procédé selon l'une quelconque des revendications 1 à 5, **caractérisé en ce que** la au moins une troisième couche métallique est appliquée sur la au moins une deuxième couche métallique en acier par séparation électro-galvanique ou séparation physique en phase gazeuse.

7. Procédé selon l'une quelconque des revendications 1 à 6, **caractérisé en ce que** la au moins une première couche métallique et/ou la au moins une deuxième couche métallique sont appliquées plusieurs fois pour obtenir un revêtement multicouche.

8. Procédé selon l'une quelconque des revendications 1 à 7, **caractérisé en ce que** la au moins une troisième couche métallique est appliquée plusieurs fois pour obtenir un revêtement multicouche.

9. Procédé selon l'une quelconque des revendications 1 à 8, **caractérisé en ce que** le substrat en acier revêtu d'une des couches métalliques est nettoyée avant l'application d'une autre couche métallique, le nettoyage se faisant de préférence par un processus sous vide à l'aide d'un plasma à l'argon.
